# EUROPEAN PATENT SPECIFICATION

(11) **EP 0 910 236 B1**
(45) Date of publication and mention of the grant of the patent: **10.12.2003**
(21) Application number: 98307896.5
(22) Date of filing: 29.09.1998
(51) Int. Cl.: H05K 9/00

(54) **Electronic apparatus**
Elektronisches Gerät
Appareil électronique

(30) Priority: 16.10.1997 JP 28327097
(43) Date of publication of application: 21.04.1999
(73) Proprietor: ALPS ELECTRIC CO., LTD., Ota-ku Tokyo 145 (JP)
(72) Inventor: Yamamoto, Masaki, Fukushima-ken (JP); Ogamoto, Kazutoshi, Soma-shi, Fukushima-ken (JP)
(74) Representative: Kensett, John Hinton

(56) References cited:
- DE-U- 8 120 399
- GB-A- 2 152 291
- US-A- 5 097 389
- PATENT ABSTRACTS OF JAPAN vol. 1995, no. 05, 30 June 1995 (1995-06-30) & JP 07 038267 A (NEC KANSAI LTD), 7 February 1995 (1995-02-07)

## Description

The present invention relates to an electronic apparatus such as a television tuner.

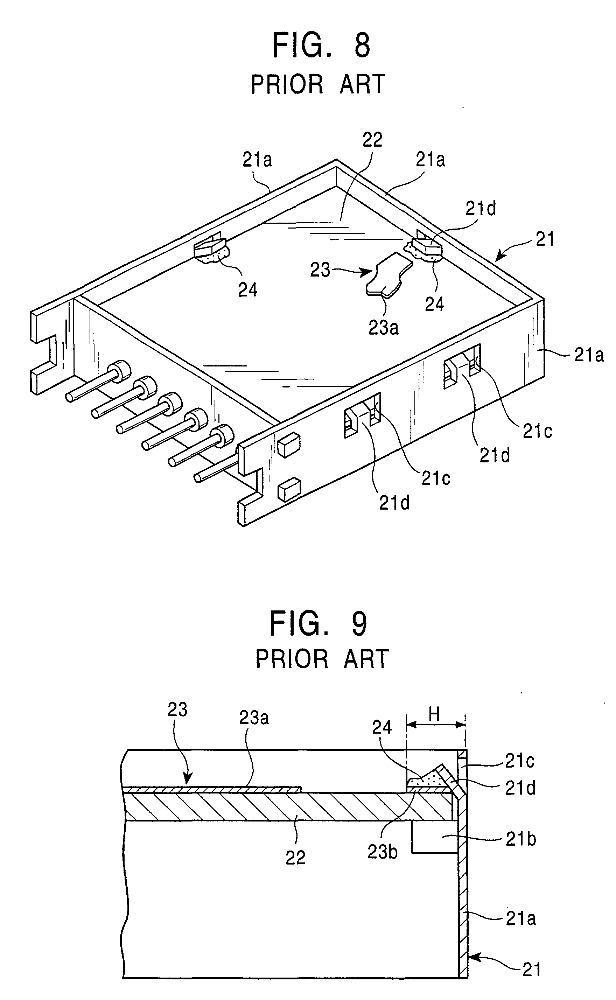

Figs. 8 through 10 show a conventional electronic apparatus. As shown in the drawings, a frame 21 is formed of metal and open on the upper and lower sides. It is equipped with a side plate 21a, engagement members 21b formed by denting part of the side plate 21a, and support members 21d formed by providing U-shaped holes 21c in the side plate 21a.

A rectangular printed circuit board 22 is equipped with a conductive pattern 23 including a wiring pattern 23a and a grounding pattern 23b.

The grounding pattern 23b is provided in the vicinity of the periphery of the printed circuit board 22 and close to the frame 21, connecting to the frame 21 at a nearer position.

This printed circuit board 22 is inserted into the frame 21, and its lower portion is engaged with the engagement members 21b. It is pressed by support members 21d bent at the upper portions thereof, the support members 21d and the grounding patterns 23b being soldered to each other with solder 24, whereby it is mounted to the frame 21.

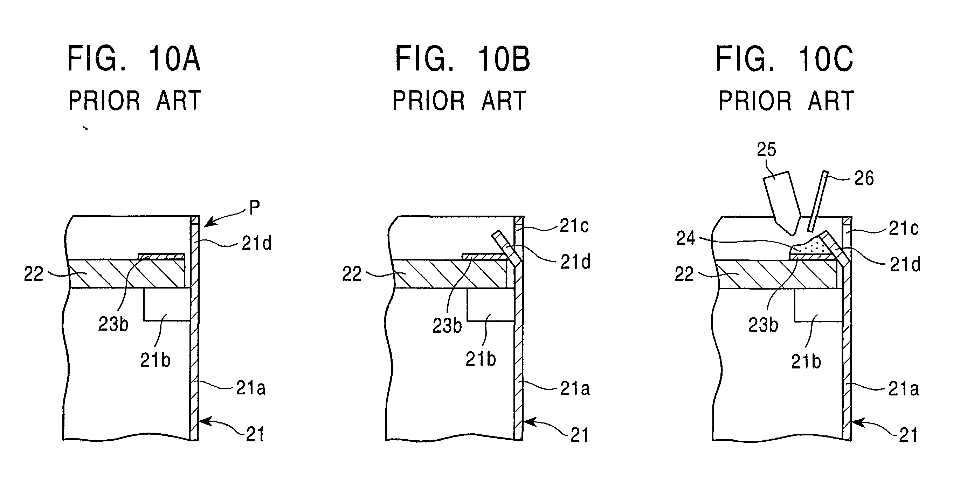

As shown in Fig. 10(A), when mounting the printed circuit board 22 to the frame 21, the printed circuit board 22 is first inserted into the frame 21, and the printed circuit board 22 is engaged with the engagement members 21b.

Next, the support members 21d are bent by a jig (not shown) from the direction P, and, as shown in Fig. 10(B), the support members 21 protrude into the frame 21 so that the printed circuit board 22 is supported by the support members 21d.

Then, as shown in Fig. 10(C), the support members 21d and the grounding patterns 23b are manually soldered to each other as indicated at 24 by using a soldering iron 25 and a wire solder 26, thereby connecting the grounding patterns 23b to the frame 21.

In the conventional electronic apparatus, it is necessary to provide the frame 21 with the engagement members 21b and the support members 21d, which involves a bothersome shaping operation and leads to poor productivity and high cost.

Further, since the support members 21d require bending, an increase in manufacturing processes is involved, resulting in poor productivity and high cost.

Further, since the soldering 24 is conducted manually, it is bothersome and takes time, resulting in high cost.

Further, since the support members 21d are bent to be soldered to the grounding patterns 23b as indicated at 24, the grounding patterns 23b must be formed so as to be positioned inside the frame 21. Thus, as shown in Fig. 9, a width H for soldering 24 is required, with the result that the size of the frame 21 and that of the printed circuit board 22 are rather large.

Reference is made to other conventional electronic apparatus described in GB-A-2,152,291 and JP-A-07038267. In these apparatus for the fitting onto a printed circuit board, protruding support portions are passed through holes of the printed circuit board.

As a first means for solving the above problems, there is provided an electronic apparatus comprising a frame member and a printed circuit board portion, the frame member having a metal side plate, the side plate including a notched portion at the upper end thereof and a support member erect in the notched portion, the support member being provided with a swelled portion, the printed circuit board having a conductive pattern on the surface thereof and a protrusion in its outer periphery, a through-hole being provided at the base of the protrusion, a conductive pattern being provided on the surface around the through-hole, the protrusion of the printed circuit board protruding to the exterior of the frame member from the notched portion of the side plate, with the support member of the side plate being forcibly fitted into the through-hole of the printed circuit board, the support member being soldered to the conductive pattern and connected thereto.

As a second means for solving the above problems, the height of the support member of the side plate is such that it does not protrude from the upper end of the side plate.

Preferably, the height of the support member of the side plate is such that it does not protrude from the upper end of the side plate.

Embodiments of the invention, which is defined by appended claim 1, will now be described, by way of example only, with reference to the accompanying drawings, in which:
Fig. 1 is a perspective view of an electronic apparatus according to the present invention;
Fig. 2 is an essential-part sectional view of the electronic apparatus of the present invention;
Figs. 3(A) and 3(B) are diagrams illustrating a method of manufacturing the electronic apparatus of the present invention;
Fig. 4 is an essential-part perspective view showing an electronic apparatus according to an embodiment of the present invention;
Fig. 5 is an essential-part sectional view of Fig. 4;
Fig. 6 is an essential-part perspective view showing an electronic apparatus according to a second embodiment of the present invention;
Fig. 7 is an essential-part sectional view of Fig. 6;
Fig. 8 is a perspective view of a conventional electronic apparatus;
Fig. 9 is an essential-part sectional view of the conventional electronic apparatus; and
Figs. 10(A) through 10(C) are diagrams illustrating a method of manufacturing the conventional electronic apparatus.

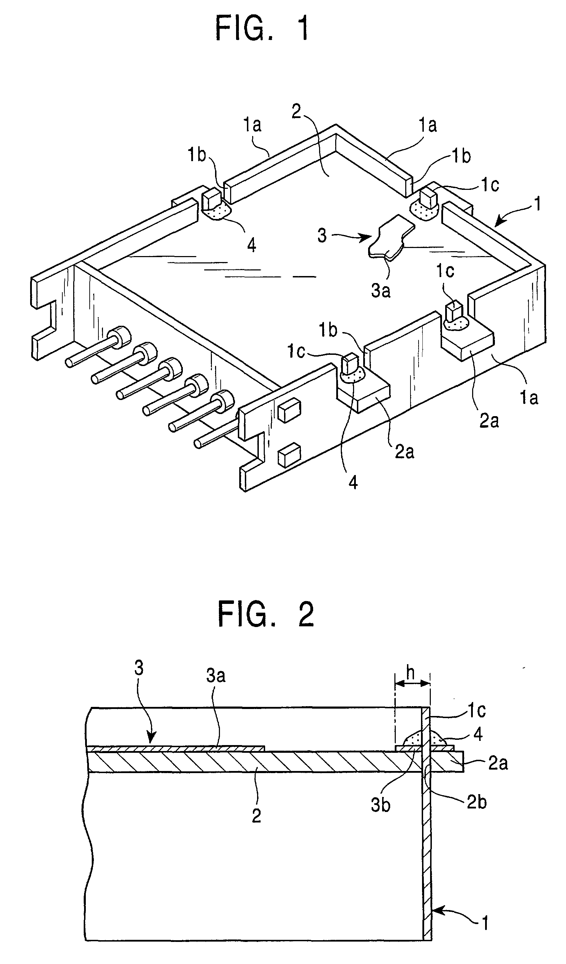

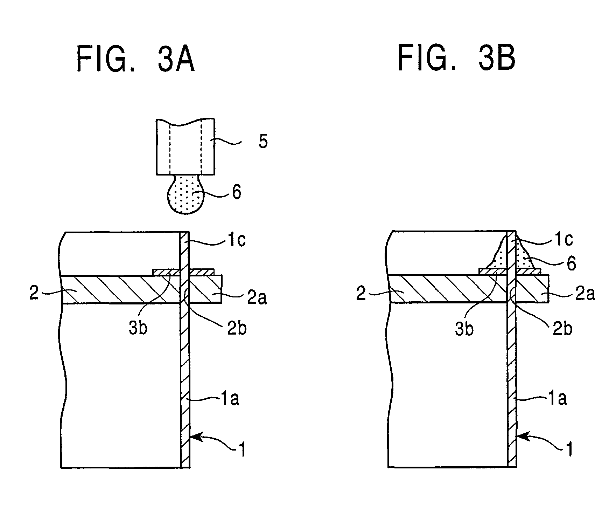

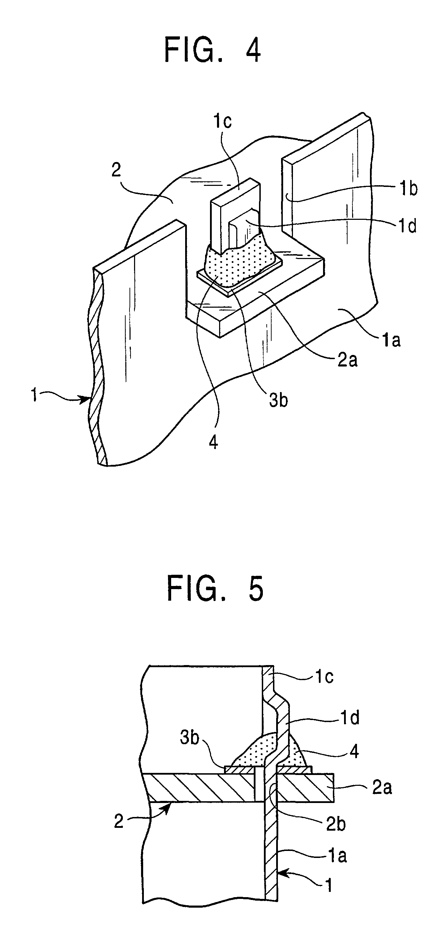

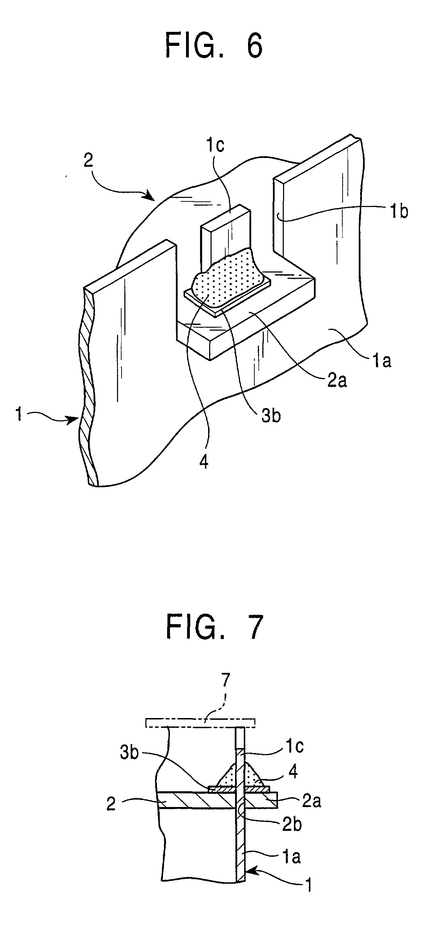

Electronic apparatus according to the present invention will be described with reference to Figs. 1 through 7. Fig. 1 is a perspective view of an electronic apparatus according to the present invention; Fig. 2 is an essential-part sectional view of the electronic apparatus of the present invention; Figs 3(A) and 3(B) are diagrams illustrating a method of manufacturing the electronic apparatus of the present invention; Fig. 4 is an essential-part perspective view showing an electronic apparatus according to a second embodiment of the present invention; Fig. 5 is an essential-part sectional view of Fig. 4; Fig. 6 is an essential-part perspective view showing an electronic apparatus according to a second embodiment of the present invention; and Fig. 7 is an essential-part sectional view of Fig. 6.

As shown in Figs. 1 through 3, the electronic apparatus of the present invention includes a rectangular metal frame member 1, which is equipped with a side plate 1a that is open on the upper and lower sides and protruding support portions 1c formed by forming notched portions 1b from the upper end of the side plate 1a.

Though not shown, the open portion of the frame member 1 is covered so as to electrically shield the interior of the frame member 1.

The rectangular printed circuit board 2 includes rectangular protrusions 2a protruding from the outer periphery, holes 2b provided in the protrusions 2a, and conducting patterns 3 consisting of a wiring pattern 2a formed on the printed circuit board 2 and grounding patterns 3b.

The grounding patterns 3b are formed in the periphery of the printed circuit board 2 and around the holes 2b.

In this printed circuit board 2, the protrusions 2a are positioned in the notched portions 1b, and the support portions 1c are passed through the holes 2b, the lower portions of the protrusions 2a being engaged with the bottom surfaces of the notched portions 1b. In this condition, the support portions 1c and the grounding patterns 3b are soldered to each other as indicated at 4, whereby the printed circuit board 2 is mounted to the frame member 1.

Due to this construction, in which the grounding patterns 3b are soldered to the support portions 1c positioned in the notched portions 1b as indicated at 4, it is possible for the central portions of the grounding patterns 3b to be positioned outside the side plate 1a, whereby the width h for the soldering 4 in the frame member 1 can be reduced.

As shown in Fig. 3(A), in the method of manufacturing this electronic apparatus, the protrusions 2a of the printed circuit board 2 are first positioned in the notched portions 1b of the frame member 1, and the support portions 1c are passed through the holes 2, the lower portions of the protrusions 2a being temporarily engaged with the bottom surfaces of the notched portions 1b.

Next, this frame member 1 is conveyed to a solder paste applying machine by a belt, and a nozzle 5 of the solder paste applying machine is positioned above the support portion 1c, causing solder paste 6 to drop from the nozzle 5.

Then, as shown in Fig. 3(B), the solder paste 6 flows down to the grounding pattern 3b, so that the solder paste 6 exists between the support member 1c and the grounding pattern 3b.

Next, when this frame member 1 is conveyed to a heating furnace, the solder paste 6 is heated and, as shown in Figs. 1 and 2, the support portion 1c and the grounding pattern 3b are soldered together as indicated at 4, whereby the automatic manufacturing of the electronic apparatus is completed.

Figs. 4 and 5 show an embodiment with respect to the support portion 1c of the above-described embodiment. In this embodiment, the support portion 1c is provided with a protrusion 1d, and this protrusion 1d is forced into the hole 2b of the printed circuit board 2 to temporarily engage the printed circuit board 2 with the frame member 1.

Due to this construction, detaching and rattling of the printed circuit board 2 when the frame member 1 is conveyed to - the solder paste applying machine and the heating furnace are prevented.

Figs. 6 and 7 show the second embodiment of the electronic apparatus of the present invention. In this embodiment, the position of the upper end of the support portion 2c is lower than the upper end of the side plate 1a, so that, when the cover 7, indicated by a two-dot chain line in Fig. 7, is placed in position, the upper end of the support portion 1c does not abut the cover 7.

Due to this construction, when rattling is generated in the electronic apparatus by vibrations, etc., the support portion 1c, whose upper end is spaced apart from the side plate 1a, is not brought into contact with or separated from the cover 7, whereby the noise due to contact/separation is prevented.

Apart from the above, the construction of this embodiment is the same as that of the first embodiment, so the components which are the same as those of the first embodiment are indicated by the same reference numerals, and a description of such components will be omitted.

In the frame member 1 of the electronic apparatus of the present invention, the notched portion 1b extending from the upper end of the side plate 1a is provided to form the protruding support portion 1c, whereby it is possible to provide an electronic apparatus which is simpler in construction, improved in productivity and less expensive as compared with the conventional electronic apparatus.

Further, since it is only necessary to pass the support portions 1c through the holes 2b of the printed circuit board 2, there is no need to perform bending as in the prior art, whereby it is possible to provide an inexpensive electronic apparatus having satisfactory productivity.

Further, since the support portion 1c is passed through the hole 2b of the printed circuit board 2, and the support portion 1c and the grounding pattern 3b is soldered to each other as indicated at 4, the width h for soldering 4 in the frame member 1 can be reduced, whereby the frame 1 and the printed circuit board 2 can be reduced in size, thereby making it possible to provide a small-sized electronic apparatus.

Further, since the printed circuit board 2 is temporarily engaged by providing the support portion 1c with the protrusion 1d and forcing the protrusion 1d into the hole 2b of the printed circuit board 2, the position of the printed circuit board 2 with respect to the frame member 1 is stabilized, whereby it is possible to provide an electronic apparatus in which the support portion 1c and the grounding pattern 3b are reliably soldered to each other.

Further, since the position of the upper end of the support portion 1c is lower than the upper end of the side plate 1a, the support portion 1c separated from the side plate 1a at the upper end does not come into contact with or move away from the cover 7 when rattling is generated due to vibrations, etc. of the electronic apparatus, whereby it is possible to provide a high performance electronic apparatus.

Further, since there is a process in which solder paste 6 is dropped from above the support portion 1c formed by forming the notched portion 1b from the upper end of the side plate 1a to thereby cause the solder paste 6 to exist between the support portion 1c and the grounding pattern 3b, so that manufacturing by an automatic machine is possible, whereby it is possible to provide an inexpensive electronic apparatus having satisfactory productivity.

Further, since there is a process in which the protrusion 1d of the support portion 1c is forced into the hole 2b of the printed circuit board 2 to thereby temporarily fix the printed circuit board 2, it is possible to provide an electronic apparatus which involves no detaching or rattling of the printed circuit board 2 when conveying the frame 1, thereby making it possible to provide an electronic apparatus produced in a stable manner.

## Claims

1. Electronic apparatus comprising;
a frame member (1) having a metal side plate (1a) including a notched portion (1b) at the upper end thereof and a support member (1c) erect in the notched portion (1b), the support member being provided with a swelled portion,
a printed circuit board (2) having a conductive pattern (3b) on its surface, a protrusion (2a) in its outer periphery, a through-hole (2b) at the base of the protrusion, and a conductive pattern (3b) on the surface around the through-hole (2b),
wherein, due to the swelled portion, the support member (1c) of the side plate is forcibly fitted into the through-hole (2b) of the printed circuit board (2), such that the position of the printed circuit board (2) with respect to the frame member (1) is stabilized, and in this condition, the protrusion (2a) of the printed circuit board (2) is protruded to the exterior of the frame member from the notched portion (1b) of the side plate (1a), with the support member being soldered to said conductive pattern (3b) and connected thereto.

## Patentansprüche

1. Elektronisches Gerät, umfassend;
ein Rahmenglied (1) mit einer Metallseitenplatte (1a), welche einen gekerbten Abschnitt (1b) an deren oberen Ende umfasst, wobei ein Stützglied (1c) in den gekerbten Abschnitt (1b) vorragt, wobei das Stützglied mit einem ausgebauchten Abschnitt versehen ist,
eine gedruckte Leiterplatte (2) mit einem Leitermuster (3b) auf ihrer Oberfläche, einem Vorsprung (2a) in ihrem Außenumfang, einem Durchgangsloch (2b) an der Basis des Vorsprungs, und einem Leitungsmusters (3b) an der Oberfläche um das Durchgangsloch (2b) herum
bei welchem, aufgrund des ausgebauchten Abschnitts, das Stützglied (1c) der Seitenplatte in das Durchgangsloch (2b) der gedruckten Leiterplatte (2) gezwängt wird, derart, dass die Position der gedruckten Leiterplatte (2) in Bezug auf das Rahmenglied (1) stabilisiert ist, und, in diesem Zustand der Vorsprung (2a) der gedruckten Leiterplatte (2) zur Außenseite des Rahmenglieds von dem gekerbten Abschnitt (1b) der Seitenplatte (1a) vorragt, wobei das Stützglied an das genannte Leitungsmuster (3b) gelötet und damit verbunden ist.

## Revendications

1. Un appareil électronique comprenant:
un membre formant un cadre (1) ayant une plaque de métal latérale (1a) dont une partie à entaille (1b) à son extrémité supérieure, et un membre de soutien (1c) se dressant dans la portion à entaille (1b), le membre de soutien comportant une portion enflée,
une carte imprimée (2) ayant un placage métallique sélectif (3b) sur sa surface, une saillie (2a) sur son pourtour extérieur, un orifice de passage (2b) au pied de la saillie et un placage métallique sélectif (3b) sur la surface entourant l'orifice de passage (2b),
dans lequel, grâce à la portion enflée, le membre de soutien (1c) de la plaque latérale est fixé avec force dans l'orifice de passage (2b) de la carte imprimée (2) de façon telle que la position de la carte imprimée (2) est stabilisée par rapport au cadre (1) et dans cet état, la saillie (2a) de la carte imprimée (2) est poussée vers l'extérieur du cadre de la portion entaillée (1b0 de la plaque latérale (1a), le membre de soutien étant soudé audit placage métallique sélectif (3b) et connecté à ce dernier.
